# EUROPEAN PATENT APPLICATION

(11) **EP 2 128 549 A1**
(43) Date of publication of application: **02.12.2009**
(21) Application number: 07702143.4
(22) Date of filing: 19.01.2007
(51) Int. Cl.: F28D 15/04, F28D 15/02, H01L 23/427, H01L 23/46

(54) **HEAT PIPE HAVING FLAT END FACE AND METHOD THEREOF**

(71) Applicant: NeoBulb Technologies, Inc., Bandar Seri Begawan (BN)
(72) Inventor: Jen-Shyan CHEN, Taiwan 30046 (CN)
(74) Representative: Goddar, Heinz J.
(86) International application number: PCT/CN2007/000212
(87) International publication number: WO 2008/089599

(57) **Abstract**

The invention is to provide a method for making a heat pipe with a flat end. The method comprises the steps of : (a) providing a first tube, including a first open end and a second open end; (b) providing a second tube, including a third open end and a flat closed end; (c) seal jointing the second open end of the first tube and the third open end of the second tube to form a third tube; (d) forming a porous capillary diversion layer on the inner wall of the third tube; (e) injecting a working fluid into the third tube; (f) vacuuming the third tube, and (g) sealing the first open end.

## Description

### BACKGROUND OF THE INVENTION

### 1. Field of the invention

The invention relates to a heat pipe and a manufacturing method thereof, and more particularly, the heat pipe has a flat end so that an electrical device can be smoothly connected onto the flat end of the heat pipe.

### 2. Description of the prior art

With the development of technology, many electronic products face the problem of heat-dissipating. For example, a lot of heat is generated when the central processing unit of a computer is operated. If the heat is not removed, the operation of the entire system will be impacted. Therefore, the heat pipe plays an important role in the heat-dissipating of the central processing unit in the computer.

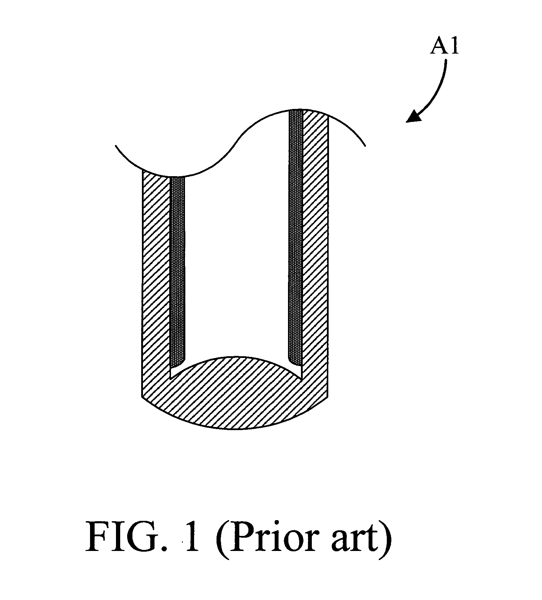

The well-known method of manufacturing a sintering heat pipe is to seal one end of a metal tube in a high temperature fusing way. Then, a metal rod is put in the tube and a metal powder is infilled in the tube. After the sintering process, the metal rod is removed and then the heat pipe is done. Please refer to FIG. 1. FIG. 1 shows the partial cross-sectional view of the heat pipe A1 in the prior art. As shown in FIG. 1, the metal pipe manufactured in this way has a round sealing end and a thicker wall, and the inner wall of the metal pipe lacks of capillary. Therefore, only the wall of the present heat pipe can be used and the end part of the heat pipe is not able to be used.

Therefore, the main aim of the invention is to provide a heat pipe and manufacturing method thereof. Herewith an electrical device can be smoothly connected onto the flat end of the heat pipe.

### SUMMARY OF THE INVENTION

In order to achieve the above-mentioned aim and solve the above-mentioned drawback, the invention provides a heat pipe and manufacturing method thereof. Herewith an electrical device can be smoothly connected onto the flat end of the heat pipe.

The heat pipe according to the invention comprises a first tube and a second tube. The first tube has a first end and a second end; the second tube has a third end and the flat end. The first tube can be a hollow metal tube, and the first end and the second end are both open. The third end of the second tube and the second end of the first tube are sealed and connected so that a third tube is formed by the first tube and the second tube. The sealing process can a soldering process, a welding process, a mechanical buckling process, or an agglutinating process. In addition, the second tube can be made by a powder metallurgy process, a punching process, an injection molding process, a casting process, or a machining process. The flat end can be in a flat form or in a concave form. It depends on the practical application.

According to the invention, a multi-hole capillary conducting layer is formed on the inner wall of the third tube. A working fluid is injected into the third tube from the first end of the first tube and the heat pipe is formed by sealing. Before the sealing, the heat pipe must be vacuumed to let the inside of the heat pipe reach a necessary vacuum so that the working fluid can work normally.

In addition, the multi-hole capillary conducting layer can be made by the following methods, but not limited by these methods. In the first method, a first metal powder is put into the third tube (at this time, the first end of the first tube is not sealed yet). Then, a center bar is inserted into the third tube from the first end and the center bar is against the first metal powder and a second metal powder is infilled between the center bar and the third tube. Afterward, a sintering process is performed to weld the first metal powder and the second metal powder to form the multi-hole capillary conducting layer. At last, the center bar is drawn out from the third tube. By the way, the first metal powder can be replaced by a sintered metal powder layer.

In the second method, a plurality of fine notches is on the inner wall of the third tube. The procedures of the second method are as follows. At first, a metal powder is put into the third tube (at this time, the first end of the first tube is not sealed yet). Then, a center bar is inserted into the third tube from the first end and the center bar is against the metal powder. Afterward, a sintering process is performed to weld the metal powder and the plurality of fine notches to form the multi-hole capillary conducting layer. At last, the center bar is drawn out from the third tube.

The third method is to make a plurality of fine notches on the inner wall of the third tube by a machining process to form the multi-hole capillary conducting layer.

The fourth method is to sinter a plurality of metal particles on the inner wall of the third tube. And then a metal mesh is set upon the plurality of metal particles to form the multi-hole capillary conducting layer.

The fifth method is to lay an undulant metal cloth upon the inner wall of the third tube. And then a smooth metal mesh cloth layer is set upon the undulant metal cloth to form the multi-hole capillary conducting layer.

The first metal powder and the second metal powder in the first method and the metal powder in the second method can be a copper powder, a nickel powder, a silver powder, a copper-plated powder, a nickel-plated powder, a silver-plated powder, or any other similar metal powder. Besides, the first tube and the second tube can be made of a copper, a nickel, a silver, or any other similar metal.

In addition, if a plurality of fine notches are formed upon both of the inner wall of the first tube and the inner wall of the second tube, the multi-hole capillary conducting layer is formed by the fine notches of the inner wall of the first tube and the inner wall of the second tube after the first tube and the second tube are sealed. Any further process is not necessary. And, the inner wall of the flat end of the heat pipe is not necessary to comprise the multi-hole capillary conducting layer. Therefore, in the above-mentioned condition, the inner wall of the flat end of the second tube is not limited by the plurality of fine notches.

To sum up, the heat pipe according to the invention has a flat end so that an electrical device can be smoothly connected onto the flat end of the heat pipe. More specifically, a multi-hole capillary conducting layer can be set upon the inner wall of the flat end of the heat pipe to let the working fluid circulate more smoothly and make the heat-dissipating effect of the electrical device better.

The advantage and spirit of the invention may be further understood by the following recitations together with the appended drawings.

### BRIEF DESCRIPTION OF THE APPENDED DRAWINGS

FIG. 1 shows a partial cross-sectional view of a heat pipe in the prior art.
FIG. 2A shows a cross-sectional view of a first tube according to a preferred embodiment.
FIG. 2B shows a cross-sectional view of a second tube according to the preferred embodiment.
FIG. 2C shows a cross-sectional view of a second tube according to an embodiment.
FIG. 3A shows a cross-sectional view of a third tube according to the preferred embodiment.
FIG. 3B shows a cross-sectional view of the third tube after the soldering process according to an embodiment.
FIG. 3C shows a cross-sectional view of the third tube after the welding process according to an embodiment.
FIG. 3D shows an exploded cross-sectional view of the first tube and the second tube according to an embodiment.
FIG. 3E shows a cross-sectional view of the third tube after the welding process according to the embodiment.
FIG. 3F shows a cross-sectional view of the third tube after the spiral agglutinating process according to an embodiment.
FIG. 3G shows a cross-sectional view of the third tube after the wedging process according to an embodiment.
FIG. 3H shows a cross-sectional view of the third tube according to an embodiment.
FIG. 4A shows a cross-sectional view of putting a first metal powder into the third tube according to the first method.
FIG. 4B shows a cross-sectional view of inserting a center bar into the third tube and the center bar is against the first metal powder according to the first method.
FIG. 4C shows a cross-sectional view of a multi-hole capillary conducting layer formed upon the inner wall of the third tube according to the first method.
FIG. 4D shows a cross-sectional view of inserting a center bar into the third tube and the center bar is against a metal powder according to the second method.
FIG. 4E shows a cross-sectional view of the third tube after a machining process according to the third method.
FIG. 4F shows a cross-sectional view of a plurality of metal particles and a metal mesh set upon the third tube according to the fourth method.
FIG. 4G shows a cross-sectional view of an undulant metal cloth and a smooth metal mesh cloth layer set on the third tube according to the fifth method.
FIG. 5 shows a schematic diagram of using a fine tube to inject a working fluid into the third tube according to the preferred embodiment.
FIG. 6 shows a cross-sectional view of the heat pipe according to the preferred embodiment of the invention.

### DETAILED DESCRIPTION OF THE INVENTION

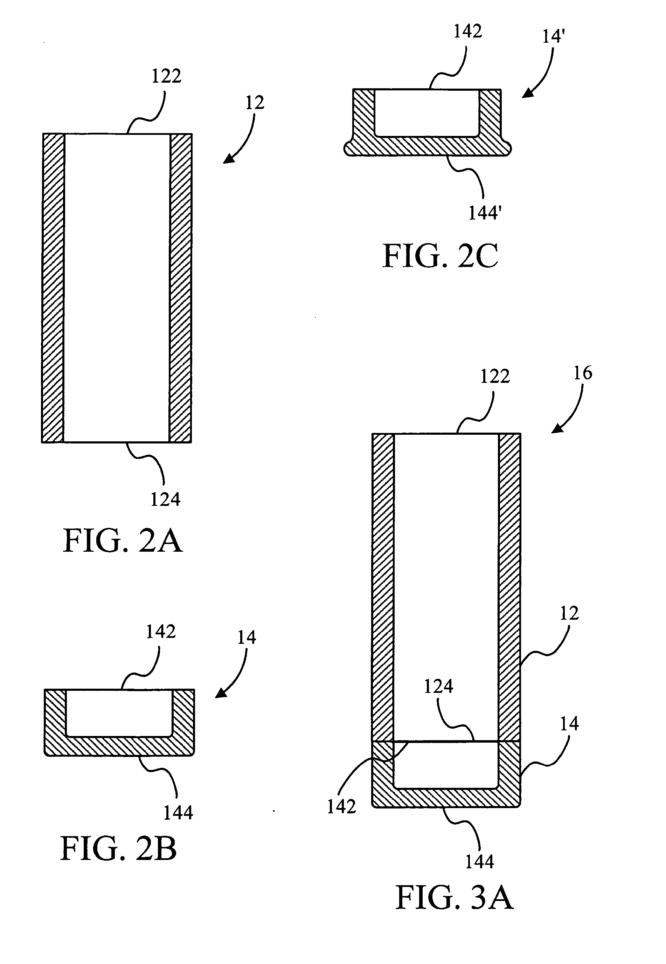

In a preferred embodiment according to the invention, the manufacturing method of a heat pipe 1 provides a first tube 12 and the first tube 12 is a hollow metal tube, as shown in FIG. 2A. FIG. 2A shows a cross-sectional view of the first tube 12. The first tube 12 has a first open end 122 and a second open end 124. Then, the method provides a second tube 14 and the second tube 14 is also a metal tube, as shown in FIG. 2B. FIG. 2B shows a cross-sectional view of the second tube 14. The second tube 14 has a third open end 142 and the flat end 144. The second tube 14 can be formed by punching a metal board, but not limited to this way. For example, the second tube 14 can also be made by injecting, molding, casting, sintering, or second manufacturing. It should be noticed that a flat area is on the surface of the flat end 144 so that an electrical device can be set on the flat end 144. However, the shape of the flat end 144 is not necessary to be a flat form. It depends on the practical applications. In an embodiment, the flat end 144' can be in a concave form or the second tube 14 can be a "T" form; namely, the cross-section of the flat end 144' is larger than the cross-section of the second tube 14' to match different electrical device configuration, as shown in FIG. 2C. FIG. 2C shows a cross-sectional view of the second tube 14' according to the embodiment. The cross-sectional view shows the second tube 14 is in the "T" form. The shapes of the second tube 14 can be easily made by combining the above-mentioned processes, so it is not described again here.

It should be noticed that if the second tube 14 is made by a punching process, then FIG. 2C should be modified. This is well-known to those skilled in the art, so it is not described again here. In addition, the material of the first tube 12 and that of the second tube 14 are not necessary to be the same. And, the cross-section of the first tube 12 and that of the second tube 14 are not necessary to be in a round form. It depends on the practical applications. For example, the shape of the cross-section can be a rectangle or a triangle. In principle, the cross-section of second open end 124 of the first tube 12 should match that of third open end 142 of the second tube 14.

Then, the second open end 124 of the first tube 12 and the third open end 142 of the second tube 14 are sealed to form a third tube 16, as shown in FIG. 3A. FIG. 3A shows the cross-sectional view of the third tube 16. The sealing process can be a soldering process, a welding process, a mechanical buckling process, an agglutinating process, or any other process which can seal two items. By the way, FIG. 3A is only a schematic diagram, and it does not show that the sealing process belongs to which one of the above-mentioned processes. Each of the different sealing processes will be explained by the following embodiments respectively. However, it is not limited to the embodiments in practical applications.

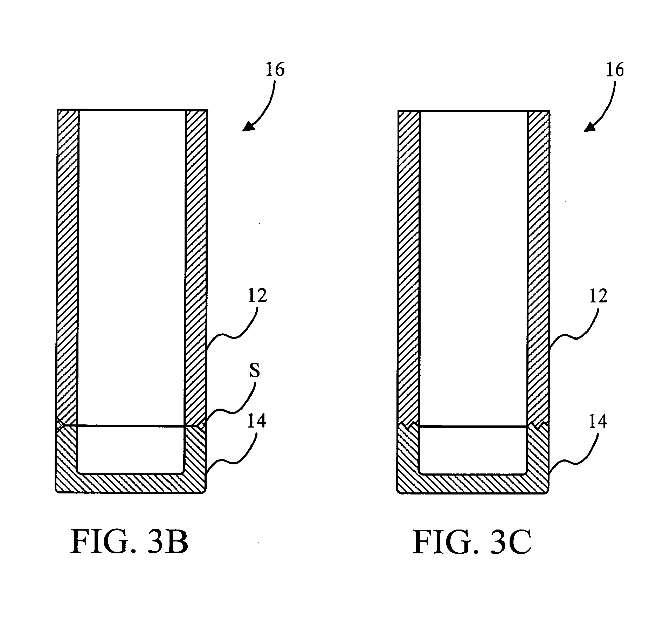

In an embodiment, the sealing process is a soldering process. A "V" shape groove can be reserved in advance at the sealing point between the second open end 124 of the first tube 12 and the third open end 142 of the second tube 14. The groove can be used for infilling the solder S so that the solder S will not protrude the surface of the third tube 16 too much, as shown in FIG. 3B. FIG. 3B shows the cross-sectional view of the third tube 16 after the soldering process is performed. However, the method of the invention is not limited to this embodiment. For example, in certain designs, the protrusion caused by the soldering process can be used to connect to the electrical device. It should be noticed that the soldering process is not the only requirement. In principle, after the soldering process, the inner wall of the first tube 12 and the inner wall of the second tube 14 should be as continually smooth as possible for the sake of the formation of the multi-hole capillary conducting layer, but it is not limited to this case. This is because the plane discontinuities allowed by the formation of different conducting layers are also diverse.

In an embodiment, the sealing process is a welding process. The sealing point of the second open end 124 of the first tube 12 and the third open end 142 of the second tube 14 is in a sawtooth form so that the second open end 124 and the third open end 142 can be further fused, as shown in FIG. 3C. FIG. 3C shows the cross-section view of the third tube 16 after the welding process is performed. It should be noticed that the sawtooth form should be vanished after the welding process, but it is still shown in FIG. 3C.

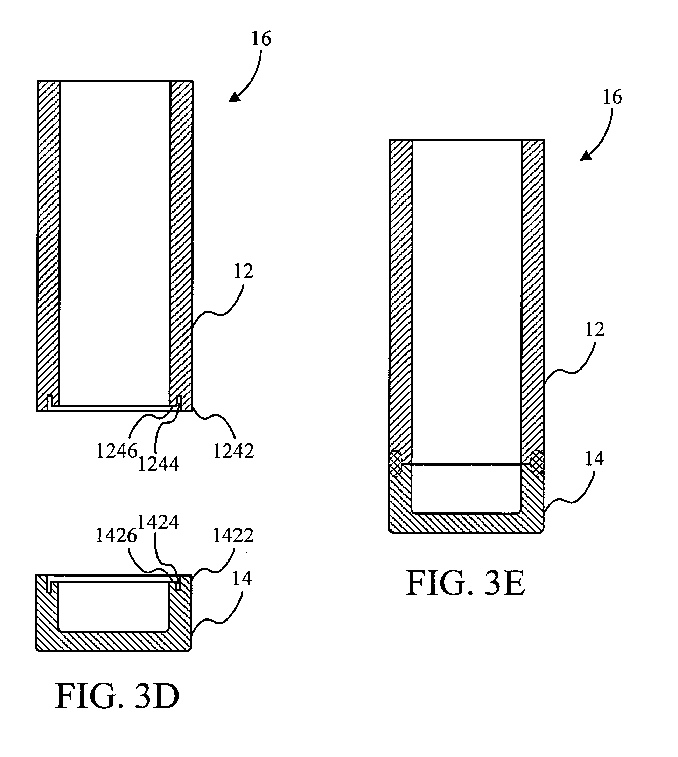

In another embodiment, the second open end 124 and the third open end 142 both have a relative protrusion 1242 and 1422 for keep the sealing point continually smooth after the welding process, as shown in FIG. 3D and FIG. 3E. FIG. 3D shows the exploded cross-sectional view of the first tube 12 and the second tube 14. FIG. 3E shows a cross-sectional view of the third tube 16 after the welding process. Please refer to FIG. 3D. The second open end 124 of the first tube 12 comprises a concavity 1244 and a surface 1246, and the third open end 142 of the second tube 14 also comprises a concavity 1424 and a surface 1426. When the protrusions 1242 and 1422 are fused to each other, the partial fused protrusions 1242 and 1422 can be infilled into the concavity 1244 and 1424 to make the surface 1246 and 1426 seamlessly agglutinated, as shown in FIG. 3E. The dotted line in FIG. 3E indicates the fused area. In addition, the protrusions 1242 and 1422 can also be in a sawtooth form.

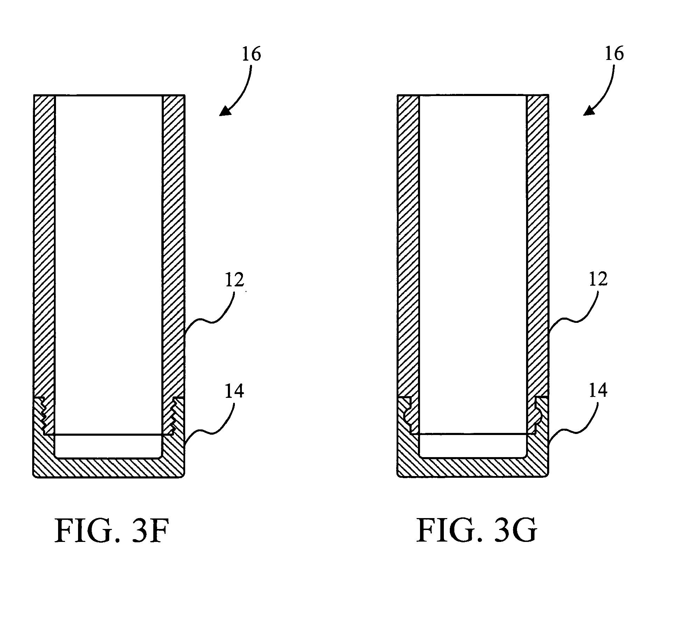

In an embodiment, the sealing process is a mechanical buckling process. The second open end 124 of the first tube 12 and the third open end of the second tube 14 are spirally connected, as shown in FIG. 3F. FIG. 3F shows the cross-section view of the third tube 16 after the spiral connection. As shown in FIG. 3F, the second open end 124 of the first tube 12 comprises a male screw, and the third open end 142 of the second tube 14 comprises a female screw correspondingly.

In practical applications, the second open end 124 of the first tube 12 can comprise a female screw, and the third open end 142 of the second tube 14 can comprise a male screw correspondingly. The screws generation step can be incorporated into the manufacturing process of the first tube 12 and the second tube 14. In another embodiment, the second open end 124 of the first tube 12 and the third open end 142 of the second tube 14 are connected by wedging, as shown in FIG. 3G. FIG. 3G shows the cross-sectional view of the third tube 16 after the wedging connection. The second open end 124 of the first tube 12 comprises a protrusion, and the third open end 142 of the second tube 14 comprises a concavity correspondingly. In general, after the wedging connection, a sealing process is performed to seal the sealing point.

In an embodiment, the sealing process is an agglutinating process. A viscose is spread on the sealing point between the second open end 124 of the first tube and the third open end 142 of the second tube 14 to agglutinate them. The shape of the connecting surface of the second open end 124 and the third open end 142 is not necessary to be a plane. In general, the moderate irregular form will be helpful to enhance the agglutinating effect. The agglutinating process can be also combined with the above-mentioned processes. For example, in the spiral connection process and the wedging process, the viscose can infiltrate the sealing gap to reach the effect of sealing and enhancing the sealing strength.

In the above-mentioned embodiments, the first tube 12 and the second tube 14 can be made of a copper, a nickel, a silver, or any other similar metal materials. And, the first tube 12 and the second tube 14 are not necessary to be made of the same material.

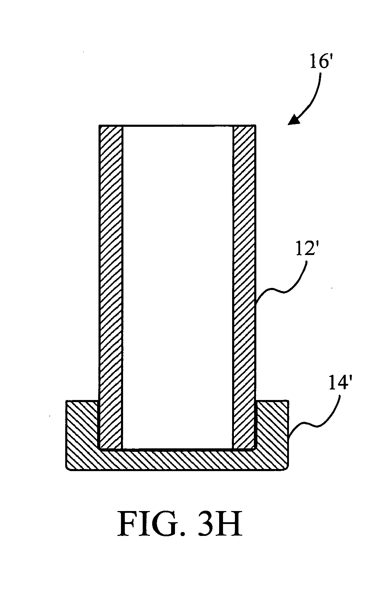

In addition, in the above-mentioned embodiments, the cross-section of the second open end 124 of the first tube 12 and that of the third open end 142 of the second tube 14 are the same. However, in an embodiment, the outer diameter of the first tube 12' equals or is slightly smaller than the inner diameter of the second tube 14' so that the first tube 12' can be inserted into the second tube 14' to form the third tube 16', as shown in FIG. 3H. FIG. 3H shows the cross-sectional view of the third tube according to the embodiment. It should be noticed that FIG. 3H is only the schematic diagram of the third tube of the embodiment. The sealing of the third tube can adopt the above-mentioned sealing process, so it is not described again here.

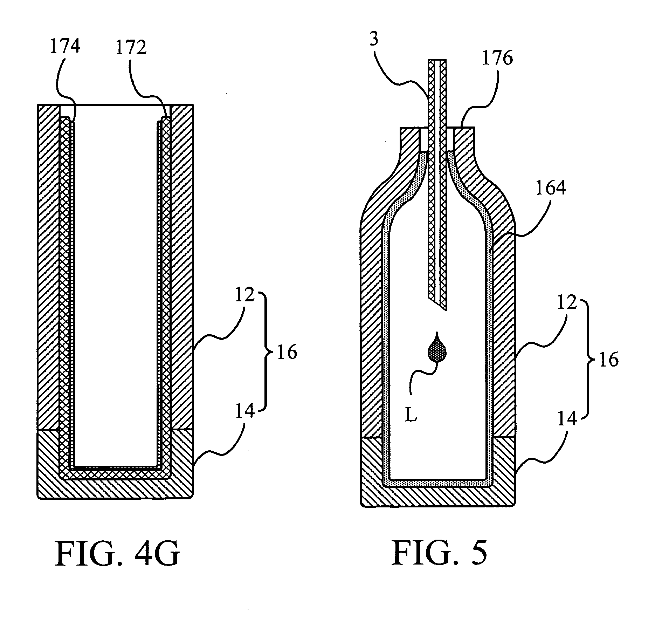

According to the preferred embodiment, after the first tube 12 and the second tube 14 are sealed, the heat pipe manufacturing method according to the invention forms a multi-hole capillary conducting layer 164 upon the inner wall of the third tube 16. Please refer to FIG. 5. The multi-hole capillary conducting layer 164 can be produced via the following methods. But it is not limited to these methods in practical applications. And, the cross-section of the second open end 124 of the first tube 12 is still the same with that of the third open end 142 of the second tube 14 in the following description, but it is not limited to this case.

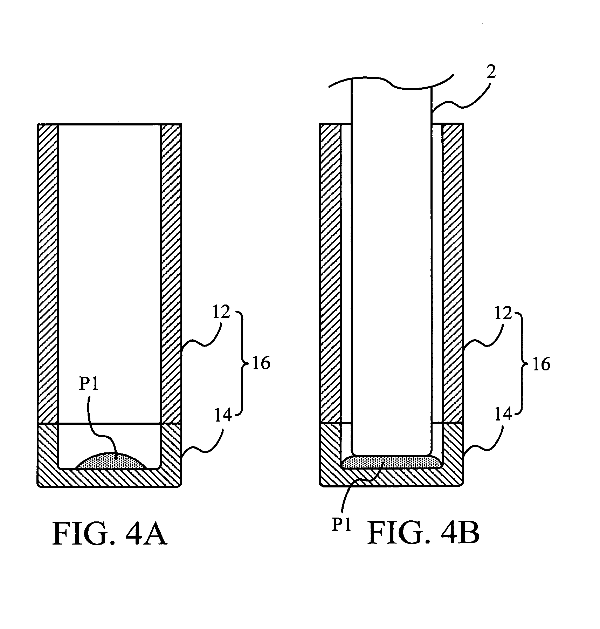

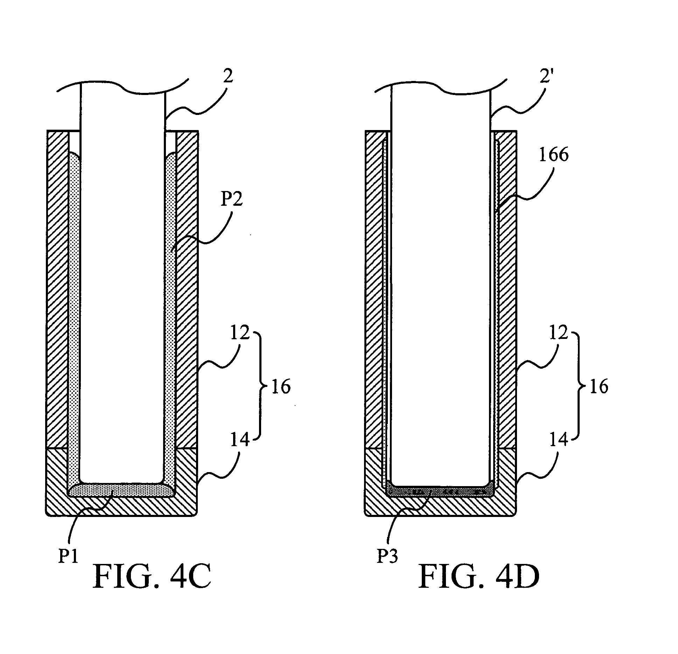

In the first method, a first metal powder P1 is firstly put into the third tube 16, as shown in FIG. 4A. FIG. 4A shows the cross-sectional view of putting the first metal powder P1 into the third tube 16. Then, a center bar 2 is inserted into the third tube 16 from the first open end 122, and the center bar is against the first metal powder P1, as shown in FIG. 4B. FIG. 4B shows the cross-sectional view of inserting a center bar 2 into the third tube 16 and the center bar 2 is against the first metal powder P1. Then, a second metal powder P2 is infilled between the center bar 2 and the third tube 16. And, a sintering process is performed to fuse the first metal powder P1 and the second metal powder P2 to form the multi-hole capillary conducting layer 164, as shown in FIG. 4C. FIG. 4C shows the cross-sectional view of the multi-hole capillary conducting layer 164 formed upon the inner wall of the third tube 16. At last, the center bar 2 is drawn out from the third tube 16. By the way, in this method, there must be a gap between the center bar 2 and the inner wall of the third tube 16 to accommodate the second metal powder P2. And, the cross-section of the center bar is not necessary to be a round form. In principle, the cross-section should match the cross-section of the third tube 16, but it is not necessary to be similar. In addition, the first metal powder P1 and the second powder P2 are not necessary to be the same. And, in this method, the first metal powder P1 can also be replaced by a sintered metal powder layer. FIG. 4B or FIG. 4C shows the figure of putting the sintered metal powder layer into the third tube. The sintered metal powder layer can be made by sintering a metal powder in advance.

In the second method, the inner wall of the third tube 16 already has a plurality of fine notches 166. At first, a metal powder P3 is put into the third tube 16, and then a center bar 2' is inserted into the third tube 16 and the center bar 2' is against the metal powder P3, as shown in FIG. 4D. FIG. 4D shows the cross-sectional view of inserting the center bar 2' into the third tube 16 and the center bar 2' is against the metal powder P3. Then, a sintering process is performed on the metal powder P3 to form a metal sintering layer. And, the metal sintering layer and the fine notches 166 are fused to form the multi-hole capillary conducting layer 164. At last, the center bar 2' is drawn out from the third tube 16. In the sintering process, the amount of the metal powder P3 must be enough to be fused with the fine notches 166. As shown in FIG. 4D, the fine notches 166 are spread on the inner wall of the first tube 12 and the inner wall of the second tube 14. However, in practical applications, if the depth of the second tube is shallow enough, the fine notches 166 can only be formed on the first tube 12. But the amount of the metal powder P3 must be enough to be fused with the fine notches 166 in the sintering process. This case can simplify the difficulties of manufacturing the second tube 14. The fine notches 166 on the inner wall of the first tube 12 can be made via a machining process.

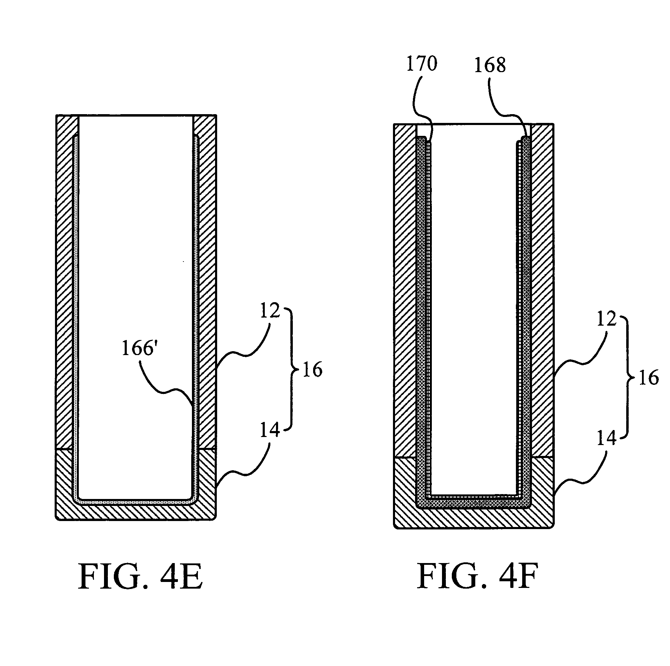

In the third method, a machining process is directly used to make a plurality of fine notches 166' on the inner wall of the third tube 16 to form the multi-hole capillary conducting layer 164, as shown in FIG. 4E. FIG. 4E shows the cross-sectional view of the third tube 16 after the machining process. It should be noticed that the multi-hole capillary conducting layer 164 can be spread on the inner wall of the flat end 144 of the second tube 14. The fine notches 166' can be generated via a cutter-cutting way, a discharging manufacturing way, or any other fine notch generating way.

In the fourth method, a plurality of metal particles 168 are sintered on the inner wall of the third tube 16 to form a metal particle layer. Then, a metal mesh 170 is set on the plurality of metal particles 168 (namely the metal particle layer) to form the multi-hole capillary conducting layer 164, as shown in FIG. 4F. FIG. 4F shows the cross-sectional view of the third tube 16 after the metal mesh 170 is set.

In the fifth method, an undulant metal cloth 172 is laid upon the inner wall of the third tube 16 at first. Then, a smooth metal mesh cloth layer 174 is set upon the undulant metal cloth 172 to form the multi-hole capillary conducting layer 164, as shown in FIG. 4G. FIG. 4G shows the cross-sectional view of the undulant metal cloth 172 and the smooth metal mesh cloth layer 174 set on the third tube 16. In fact, the shape of undulance of the undulant metal cloth 172 can be a triangle, a rectangle, a trapezoid, a wave, a complex form, or any other shapes.

In the above-mentioned methods, the first metal powder P1 and the second metal powder P2 in the first method and the metal powder P3 in the second method can be a copper powder, a nickel powder, a silver powder, a copper-plated powder, a nickel-plated powder, a silver-plated powder, or any other similar metal powder. Similarly, the metal powder used in the sintered metal powder layer in the first method can also be one of the above-mentioned powders or a mixed powder.

In addition, if a plurality of fine notches are formed upon both of the inner wall of the first tube 12 and the inner wall of the second tube 14, the multi-hole capillary conducting layer 164 is formed by the fine notches of the inner wall of the first tube 12 and the inner wall of the second tube 14 after the first tube 12 and the second tube 14 are sealed. Any further process is not necessary to form the multi-hole capillary conducting layer 164. And, the inner wall of the flat end 144 of the heat pipe 1 according to the invention is not necessary to comprise the multi-hole capillary conducting layer 164. Therefore, in the above-mentioned case, the inner wall of the flat end 144 of the second tube 14 is not limited to have the plurality of fine notches.

According to the preferred embodiment, after the multi-hole capillary conducting layer 164 is formed on the inner wall of the third tube 16, a working fluid L is injected into the third tube 16 by the method of manufacturing the heat pipe 1 according to the invention. The method can use a fine tube 3 to inject the working fluid L (as shown in FIG. 5), but it is not limited to this case. FIG. 5 shows the schematic diagram of using the fine tube 3 to inject the working fluid L into the third tube 16. The fine tube 3 is inserted into the third tube 16 from the open 176 of the third tube 16 (namely the first open end 122 of the first tube 12) and then the working fluid L is injected. The open 168 can be shrunk to a diameter which the fine tube 3 can be inserted so that the following processes of vacuuming and sealing the open 176 can be smoothly proceeded, as shown in FIG. 5.

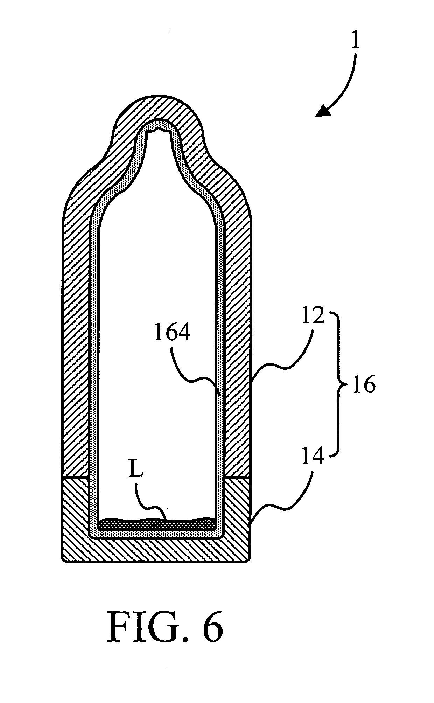

Please refer to FIG. 6. FIG. 6 shows the cross-sectional view of the heat pipe 1 according to the preferred embodiment of the invention. After the injection of the working fluid L is finished, the fine tube 3 is drawn out. Then, the third tube 16 is vacuumed to reach a required vacuum degree in the third tube 16 so that the working fluid can work normally. As shown in FIG. 6, the open 176 is sealed to form the heat pipe 1. However, FIG. 6 only shows that the open 176 of the third tube 16 is sealed. In practical applications, the sealing method and the sealed cross-sectional structure are not limited to this case. The vacuuming method and the sealing method can be performed via the conventional technologies, so the conventional technologies are not described again here. In addition, the performing sequence of the injection step and the vacuuming step can also be exchanged. It depends on the design of the practical manufacturing process.

The electrical device which is connected onto the flat end 144 of the heat pipe 1 according to the invention can be a light emitting diode (LED), a laser diode (LD), or an integrated circuit (IC).

In conclusion, the heat pipe according to the invention has a flat end, and a multi-hole capillary conducting layer set on the inner wall of the flat end so that the working fluid can be smoothly circulated. Therefore, an electrical device can be smoothly connected onto the flat end of the heat pipe to achieve good heat-dissipating effect.

With the recitations of the preferred embodiment above, the features and spirits of the invention will be hopefully well described. However, the scope of the invention is not restricted by the preferred embodiment disclosed above. The objective is that all alternative and equivalent arrangements are hopefully covered in the scope of the appended claims of the invention. Accordingly, the above disclosure should be construed as limited only by the metes and bounds of the appended claims.

## Claims

1. A method for making a heat pipe with a flat end, the method comprising the steps of:
(a) providing a first tube having a first open end and a second open end;
(b) providing a second tube having a third open end and the flat end;
(c) sealing the second open end and the third open end to form a third tube;
(d) vacuuming the third tube; and
(e) sealing the first open end;
wherein an inner wall of the third tube comprises a multi-hole capillary conducting layer and the third tube contains a working fluid.

2. The method of claim 1, wherein the working fluid is injected into the third tube before or after the step (d) is performed.

3. The method of claim 1, wherein in the step (b), the second tube is made by a powder metallurgy process, a punching process, an injection molding process, a casting process, or a machining process.

4. The method of claim 1, wherein the multi-hole capillary conducting layer is made by the steps of:
putting a first metal powder into the third tube;
inserting a center bar into the third tube from the first open end and the center bar being against the first metal powder;
infilling a second metal powder between the center bar and the third tube;
performing a sintering process for welding the first metal powder and the second metal powder to form the multi-hole capillary conducting layer; and
drawing out the center bar from the third tube.

5. The method of claim 4, wherein the first metal powder/the second metal powder is a copper powder, a nickel powder, a silver powder, a copper-plated powder, a nickel-plated powder, or a silver-plated powder.

6. The method of claim 1, wherein the multi-hole capillary conducting layer is made by the steps of:
putting a sintered metal powder layer into the third tube;
inserting a center bar into the third tube from the first open end and the center bar being against the sintered metal powder layer;
infilling a metal powder between the center bar and the third tube;
performing a sintering process for welding the sintered metal powder layer and the metal powder to form the multi-hole capillary conducting layer; and
drawing out the center bar from the third tube.

7. The method of claim 1, wherein the inner wall of the third tube comprises a plurality of fine notches, and the multi-hole capillary conducting layer is made by the steps of:
putting a metal powder into the third tube;
inserting a center bar into the third tube from the first open end and the center bar being against the metal powder;
performing a sintering process for welding the metal powder and the plurality of fine notches to form the multi-hole capillary conducting layer; and
drawing out the center bar from the third tube.

8. The method of claim 6 or 7, wherein the metal powder is a copper powder, a nickel powder, a silver powder, a copper-plated powder, a nickel-plated powder, or a silver-plated powder.

9. The method of claim 1, wherein the multi-hole capillary conducting layer is made by the step of:
making a plurality of fine notches on the inner wall of the third tube via a machining process to form the multi-hole capillary conducting layer.

10. The method of claim 1, wherein the multi-hole capillary conducting layer is made by the steps of:
sintering a plurality of metal particles upon the inner wall of the third tube; and
setting a metal mesh upon the plurality of metal particles to form the multi-hole capillary conducting layer.

11. The method of claim 1, wherein the multi-hole capillary conducting layer is made by the steps of:
laying an undulant metal cloth upon the inner wall of the third tube; and
setting a smooth metal mesh cloth layer upon the undulant metal cloth to form the multi-hole capillary conducting layer.

12. The method of claim 11, wherein the undulant metal cloth has undulance in a shape of a triangle, a rectangle, a trapezoid, or a wave.

13. The method of claim 1, wherein in step (c), the second open end and the third open end are sealed by a soldering process, a welding process, a mechanical buckling process, or an agglutinating process.

14. A heat pipe with a flat end, comprising:
a first tube having a first end and a second end, wherein the first end is sealed;
a second tube having a third end and the flat end, wherein the third end and the second end are sealed by soldering, welding, mechanical buckling, or agglutinating; and
a multi-hole capillary conducting layer formed on an inner wall of the first tube or an inner wall of the second tube;
wherein a sealed space is formed by the first tube and the second tube, and the sealed space contains a working fluid.

15. The heat pipe of claim 14, wherein the second tube is made by a powder metallurgy process, a punching process, an injection molding process, a casting process, or a machining process.

16. The heat pipe of claim 14, wherein the flat end of the second tube is in a flat form or in a concave form.

17. The heat pipe of claim 14, wherein the first tube/the second tube is made of a copper, a nickel, or a silver.

18. The heat pipe of claim 14, wherein the multi-hole capillary conducting layer is made by sintering a copper powder, a nickel powder, a silver powder, a copper-plated powder, a nickel-plated powder, or a silver-plated powder.

19. The heat pipe of claim 14, wherein the multi-hole capillary conducting layer comprises a metal particle layer and a metal mesh, the metal particle layer is sintered upon the inner wall of the first tube and the inner wall of the second tube, and the metal mesh is set upon the metal particle layer.

20. The heat pipe of claim 14, wherein the multi-hole capillary conducting layer comprises an undulant metal cloth and a smooth metal mesh cloth layer, the undulant metal cloth is laid upon the inner wall of the first tube and the inner wall of the second tube, and the smooth metal mesh cloth layer is set upon the undulant metal cloth.

21. The heat pipe of claim 14, wherein the multi-hole capillary conducting layer comprises a plurality of fine notches formed upon the inner wall of the first tube and the inner wall of the second tube via a machining process.

22. The heat pipe of claim 14, wherein the multi-hole capillary conducting layer comprises a plurality of fine notches and a metal sintering layer, the plurality of fine notches are formed upon the inner wall of the first tube and the inner wall of the second tube, and the metal sintering layer is formed upon the inner wall of the second tube and welded with the plurality of fine notches.
